# EUROPEAN PATENT SPECIFICATION

(11) **EP 0 301 571 B1**
(45) Date of publication and mention of the grant of the patent: **23.06.1993**
(21) Application number: 88112325.1
(22) Date of filing: 29.07.1988
(51) Int. Cl.: H01L 29/62, H01L 21/28, H01L 29/78, H01L 27/12, G02F 1/133

(54) **Thin film transistor array**
Dünnschichttransistoren-Matrix
Matrice de transistors en couche mince

(30) Priority: 30.07.1987 JP 193351/87
(43) Date of publication of application: 01.02.1989
(73) Proprietor: SHARP KABUSHIKI KAISHA, Osaka 545 (JP)
(72) Inventor: Tanaka, Hirohisa, Ando-cho Ikoma-gun Nara-ken (JP)
(74) Representative: VOSSIUS & PARTNER

(56) References cited:
- THIN SOLID FILMS, vol. 109, 1983, pages 339-343, Elsevier Sequoia, Lausanne, CH; P.K. REDDY et al.: "High frequency performance of Ta-Al-N capacitors made with an aluminum underlayer"
- SID INTERNATIONAL SYMPOSIUM, DIGEST OF TECHNICAL PAPERS, May 1985, pages 295-296, Palisades Institute for Research Services, Inc., New York, US; Y. ISHII et al.: "High-performance a-Si TFT array for liquid-crystal display device"

## Description

The present invention generally relates to a thin film transistor array and, more particularly, to the thin film transistor array suited for use in a large-size active matrix liquid crystal or the like.

### Description of the Prior Art:

A liquid crystal display device of active matrix drive type comprising a glass substrate having an array of thin film transistors is formed, and a liquid crystal layer and transparent electrodes overlaying the thin film transistor array one above the other, has some advantages in that the response of the liquid crystal used is high, in that no design limitation is imposed on the substrate, and in that the resultant display device can be used in the form of either a reflecting type or a transmissive type. Therefore, it is a recent trend that a number of liquid crystal display devices of active matrix drive type are used in a large-size display panel.

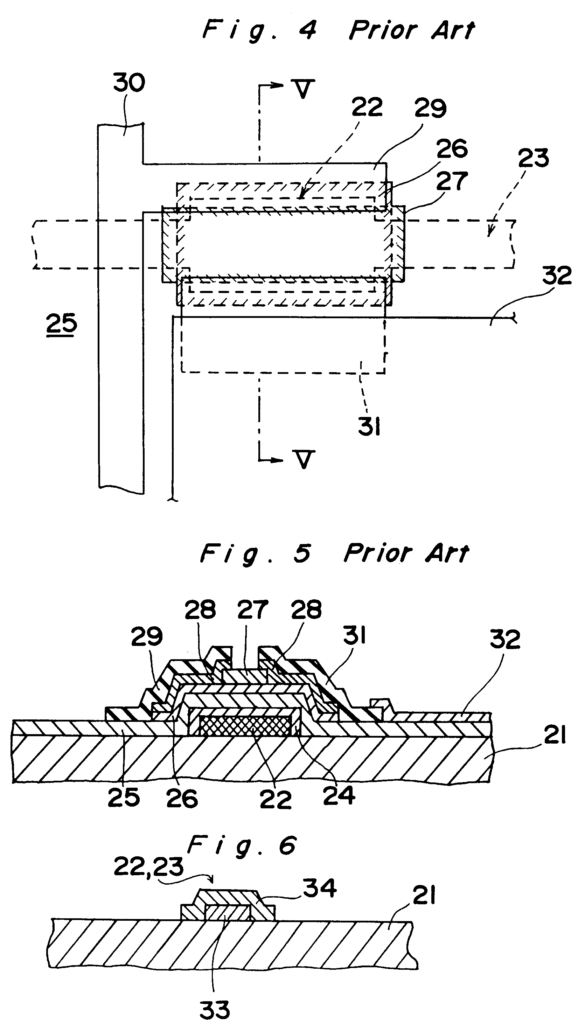

Semiconductor material for the thin film transistor array used in the prior art crystal display includes poly-Si, a-Si, Te, CdS and so on. An examples of the prior art thin film transistor array utilizing, for example, a-Si is illustrated in Figs. 4 and 5.

The thin film transistor array shown in Figs. 4 and 5 is fabricated in the following manner. By the use of the sputtering technique, a Ta layer is deposited on a glass substrate 21 to a thickness of 3,000 to 4,000Å (1Å = 0.1nm) to form a gate electrode 22 and a gate wiring 23, respective surface regions of which are subsequently anodized, i.e., anodically oxidized, to form a first gate insulating layer 24. Then, by the use of the plasma CVD technique, silicon nitride (hereinafter referred to as SiNx) is deposited to a thickness of 2,000 to 4,000Å so as to overlay the first gate insulating layer 24 and the glass substrate 21 thereby to form a second gate insulating layer 25. An a-Si layer 26 of 100 to 3,000Å and a third insulating layer 27 of narrow width made of SiNx and being 2,000 to 3,000Å in thickness are sequentially deposited one above the other by the use of the plasma CVD technique so as to overlay that portion of the SiNx layer 25 which is positioned above and aligned with the gate electrode 22. Thereafter, an a-Si layer 28 of 300 to 2,000Å in thickness and doped with phosphorus (P) is deposited so as to overlay each side of the third insulating layer 27 and, also, each side portion of the a-Si layer 26, that is exposed outside the third insulating layer 27, in a ohmic-contact fashion. At a final step, a metal of, for example, Mo, Ti or Al is deposited to a thickness of 2,000 to 10,000Å so as to overlay each a-Si layer 28 and a portion of the second gate insulating layer 25, thereby to form a source electrode 29, a source wiring 30 continued from the source electrode 29, and a drain electrode 31, followed by a deposition of, for example, indium oxide over the second gate insulating layer 25 so as to contact the drain electrode 31 thereby to complete a transparent pixel electrode 32.

In the active matrix liquid crystal display device utilizing the thin film transistor array, the liquid crystal is sequentially driven by applying a vertical scanning signal to a plurality of horizontal signal lines constituted by the respective gate wirings 23 of the thin film transistors and, on the other hand, by applying an image signal to a plurality of vertical signal lines, constituted by the respective source wirings 30 of the same thin film transistors, so that the pixel electrodes 32 of the associated thin film transistors can be electrically powered. Because of this mode of driving the active matrix liquid crystal display device, the number of points of intersection between the gate wirings 23 and the source wirings 30 in, for example, the 480 x 640 matrix, amounts to 307,200. In the event that a leakage between the gate and source electrodes occur even at one of those 307,200 points of intersections between the gate and source wirings 23 and 30, a crossshaped line defect necessarily occurs in the display at a location corresponding to such one of the points of intersections, posing a problem associated with the display quality.

In view of the foregoing, the prior art is such that, in order to accomplish a complete insulation between the gate and source, Ta material which can be anodically oxidized is employed for the gate electrodes 22 and the associated gate wirings 23 so that, as described with reference to Fig. 5, the anodization of the surface of the Ta layer can result in the formation of the first gate insulating layer 24 of Ta₂O₅. At the same time, the second gate insulating layers 25 made of SiNx are additionally formed on the first gate insulating layers 24 and the glass substrate 21 by the use of the plasma CVD technique.

In the prior art thin film transistor array of the above described construction, since the Ta material for the gate electrodes 22 and the associated gate wirings 23 has a relatively high specific resistance, the use of the thin film transistor array in the large-size matrix drive liquid crystal display device wherein the matrix wiring is of a considerable length often poses a problem in that the applied vertical scanning signal may attenuate somewhere in the gate wirings and, therefore, the liquid crystal display may not be driven sufficiently and effectively (JP-A-142371/84).

In order to substantially eliminate the above discussed problem, the necessity arises that, as shown in Fig. 6, for each thin film transistor, the gate electrode and the associated gate wiring are formed of a double-layered structure wherein an outer layer 34 is made of the Ta material that can be easily insulated and an underlayer 33 made of Cr, Ni, Au or the like having a relatively low specific resistance. However, this attempt to accomplish the complete insulation necessarily requires the formation of the outer Ta layer 34 so as to completely cover the underlayer 33 which is made of Cr, Ni, Au or the like which cannot be anodically oxidized, resulting in the increased number of fabricating steps accompanied by the increase in manufacturing cost.

SID Intenat. Symposim, Dig. Techn. Papers, May 1985, pages 295-296 discloses a high-performance a-Si TFT array for LCDs with a high ON current at low gate voltage by using an anodized film as a gate insulator.

The present invention has therefore been devised with substantially eliminating the above discussed problems inherent in the prior art and has for its essential object to provide an improved thin film transistor array wherein, while the insulation between the gate and source is accomplished of a degree similar to that accomplished according to the conventional technique, the gate electrodes and the associated gate wirings can be formed by use of and during only one masking step.

The object is solved with the features of the claim.

In the manufacture of the thin film transistor array according to the present invention, after the first, or lower, metal layer made of metal having a low electric resistance and capable of being anodized and the second, or upper, metal layer made of metal capable of being anodized have been successively formed one above the other, only a necessary portion of a surface of the second metal layer is masked by a single mask, for example, a photoresist film, and is then etched off to remove unwanted portions of the second and first metal layers thereby to allow respective opposite side edges of the first and second metal layers to be exposed to form the gate electrode. Alternatively, while an unnecessary portion of the substrate is masked by a single mask, the lower metal layer made of said metal and the upper metal layer made of said metal are successively deposited one above the other on a necessary portion of the substrate so that, in one process step, respective opposite side edges of the first and second metal layers can be exposed thereby to form the gate electrode.

Since the surface of the gate electrode is totally made of the anodizeable metal, the first insulating layer can be easily formed over the surface of the gate electrode during the subsequent anodizing step. Subsequent to the anodizing step, process steps similar to those used in the conventional process may be employed to form the second insulating layer, the semiconductor layer and the source and drain electrodes, thereby to complete the thin film transistor array.

This and other objects and features of the present invention will become clear from the following description taken in conjunction with a preferred embodiment thereof with reference to the accompanying drawings, in which:
Fig. 1 is a fragmentary plan view of a thin film transistor array embodying the present invention;
Fig. 2 is a cross-sectional view taken along the line II-II in Fig. 1;
Figs. 3(a) to 3(f) illustrate the sequence of manufacturing steps used to fabricate the thin film transistor array shown in Fig. 1;
Fig. 4 is a view similar to Fig. 1, showing the prior art thin film transistor array;
Fig. 5 is a cross-sectional view taken along the line V-V in Fig. 4; and
Fig. 6 is a sectional view showing a modification of a gate wiring portion of Fig. 5.

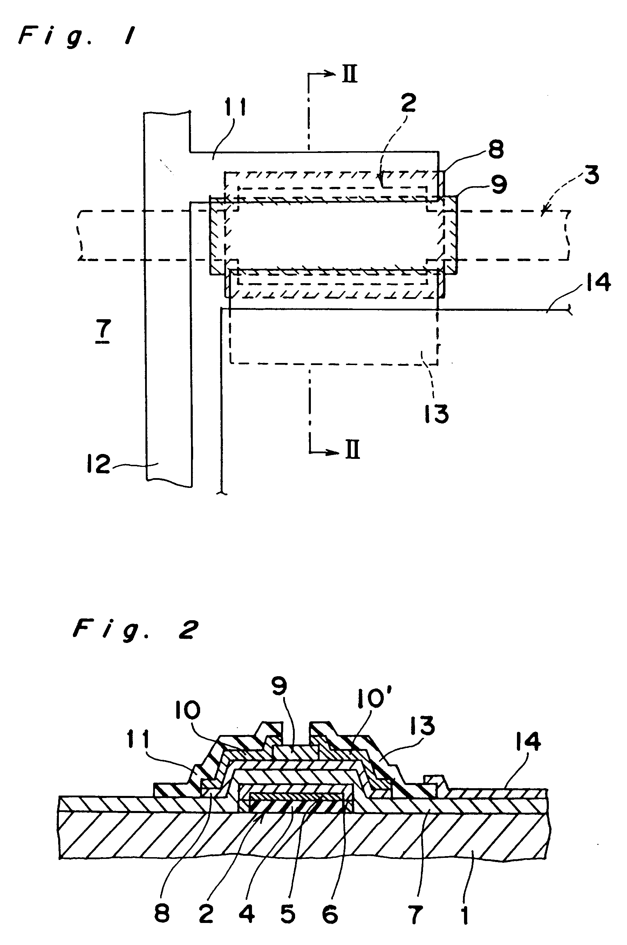

Referring first to Figs. 1 and 2, reference numeral 1 represents an insulating substrate which is employed in the form of a glass substrate. The glass substrate 1 has one surface formed with a gate electrode 2 and an associated gate wiring 3, each of which is formed by a lower metal layer, i.e., an Al layer, made of anodically oxidizable metal having a low electric resistance and an upper metal layer, i.e., a Ta layer, made of anodically oxidizable metal. Reference numeral 6 represents a first insulating layer formed by anodically oxidizing a surface region of each of the gate electrode 2 and the gate wiring 3. Reference numeral 7 represents a second insulating layer formed by depositing SiNx on the glass substrate 1 so as to overlay the first insulating layer 6. Reference numeral 8 is a semiconductor layer formed by depositing a-Si on that portion of the second insulating layer 7 which overlays the gate electrode 2. Reference numeral 9 represents a third insulating layer formed by depositing SiNx on a portion of the semiconductor layer 8 immediately above the gate electrode 2.

Reference numerals 10 and 10′ represent respective semiconductor layers formed by depositing a-Si, doped with phosphorus, so as to overlay opposite side portions of the third insulating layer 9 and, also, the semiconductor layer 8, said semiconductor layers 10 and 10′ providing an ohmic contact. Reference numerals 11 and 12 represent a source electrode and an associated source wiring, each formed by depositing Mo over the semiconductor layer 10 and also the second insulating layer 7. Reference numeral 13 represents a drain electrode formed by depositing Mo over the semiconductor layer 10′. Reference numeral 14 represents a pixel electrode formed by depositing indium oxide over the second insulating layer so as to partially overlap the drain electrode 13.

Each of the gate electrode 2 and the associated gate wiring 3 is formed by depositing the Al layer 4 of 2,000Å in thickness and the Ta layer 5 of 2,000Å in thickness successively on the glass substrate 1 by the use of a sputtering technique, followed by the photo-etching to render them to represent such a pattern as shown by the dotted lines in Fig. 1. Accordingly, opposite side edges of each of the Al layer 4 and the Ta layer 5 are exposed to the outside while lying generally perpendicular to the glass substrate 1 as shown in Fig. 2, and, by anodically oxidizing the respective opposite side edges of each of the Al and Ta layers 4 and 5 and a surface of the Ta layer 5 opposite to the Al layer 4, the first insulating layer 6 made in part of Al₂O₃ and in part of Ta₂O₃ is collectively formed.

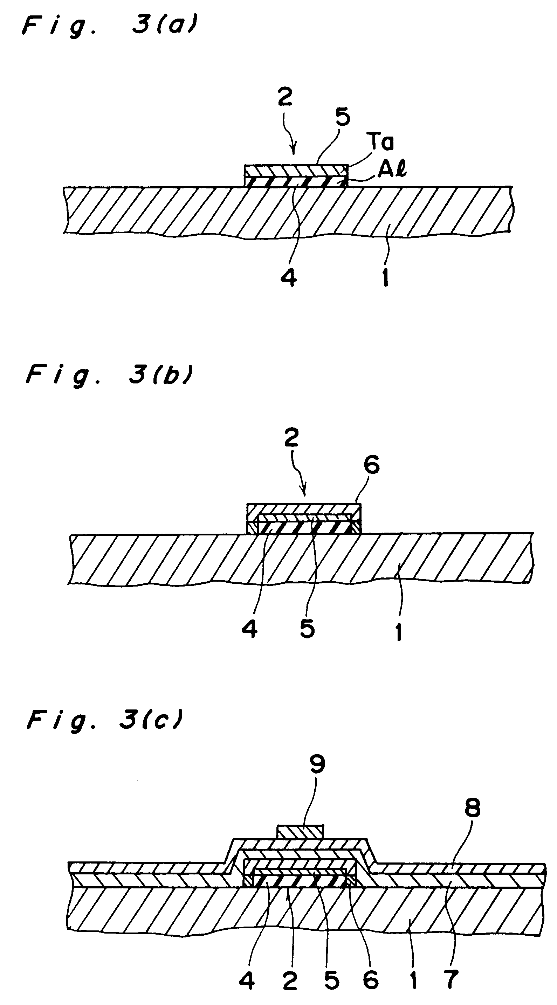

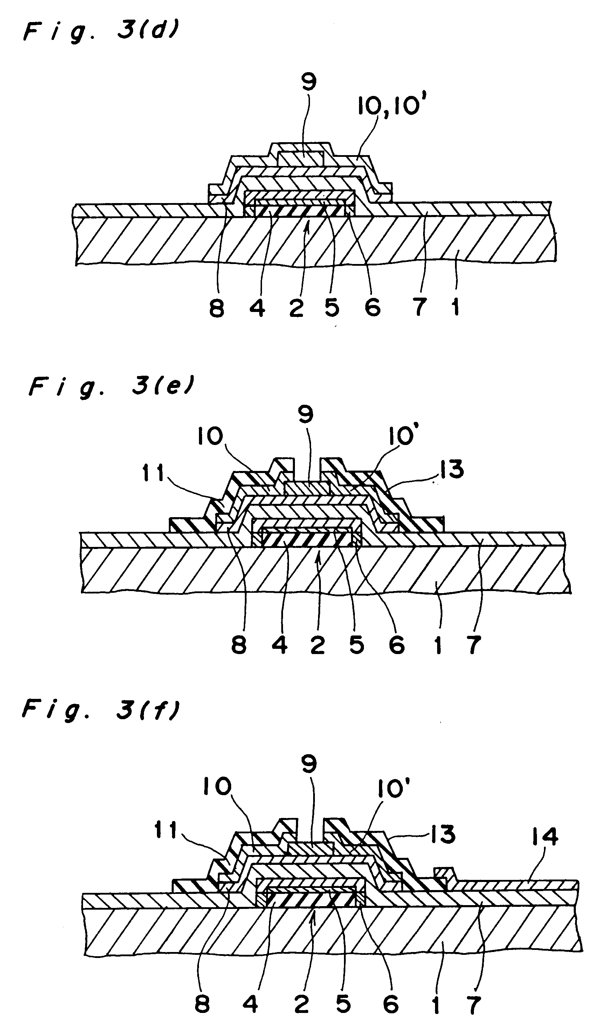

Hereinafter, the thin film transistor array of the above described construction will be described step by step with particular reference to Figs. 3(a) to 3(f).
(a) After the Al layer 4 of 2,000Å in thickness and the Ta layer 5 of 2,000Å in thickness have been successively formed one above the other on the glass substrate 1 by the use of the sputtering technique, a portion of the surface of the Ta layer 5 opposite the Al layer 4 other than a necessary portion of the surface thereof which is masked by a single mask, made of a photoresist film, is then etched off to form the gate electrode 2 and the associated gate wiring 3 of the illustrated pattern. This single etching process step with the use of the single mask makes it possible to form the gate wiring of a double-layered structure including the Al layer 4 of low electric resistance and the Ta layer 5 and, accordingly, the etching process which has hitherto required two etching steps to form the structure shown in Fig. 6 could be reduced to a single etching step and, therefore, the gate wiring having a low specific resistance enough to be applicable in the large-size thin film transistor array can be fabricated inexpensively.
(b) By anodically oxidizing respective surfaces of the gate electrode 2 and the gate wiring 3, the first insulating layer 6 is formed. Since the double-layered structure including the Al layer and the Ta layer is made of a metal capable of being anodically oxidized, the first insulating layer 6 can be easily and collectively formed.
(c) Then, by the use of the plasma CVD technique, a SiNx layer of 4,000Å in thickness which will subsequently become the second insulating layer 7, an a-Si layer of 2,000Å in thickness which will subsequently become the semiconductor layer 8, and a SiNx layer of 2,000Å which will subsequently become the third insulating layer 9 are successively deposited over the entire surface, followed by the photo-etching to form the third insulating layer 9 of the illustrated pattern.
(d) Subsequently, by the use of the plasma CVD technique, the a-Si layers 10 and 10′ doped with phosphorus and each being 1,000Å in thickness are deposited over the entire surface, followed by the photo-etching to remove opposite side portions of the a-Si layers 10 and 10′ and the semiconductor layer 8 to form the illustrated pattern.
(e) Thereafter, by the use of the sputtering technique, Ti layers 11 and 13 each being 3,000Å in thickness are deposited, followed by the photo-etching to remove respective portions of the Ti layer and the a-Si layers 10 and 10′ to provide the source electrode 11, the associated source wiring 12 and the drain electrode 13 of the illustrated pattern.
(f) As a final step, a layer of indium oxide is deposited by the use of the sputtering technique on the second insulating layer 7 so as to partially overlap the drain electrode 13, followed by the photo-etching to form the pixel electrode 14.

Since in the foregoing embodiment the provision has been made of the semiconductcr layers 10 and 10′ made of a-Si doped with phosphorus, which layers 10 and 10′ are positioned between the semiconductor layer 8, made of a-Si, and both of the source electrode 11 made of Ti and the drain electrode 13, an ohmic contact can be advantageously obtained therebetween.

As hereinbefore described, since according to the present invention the thin film transistor array comprises an insulating substrate, gate electrodes formed on one surface of the substrate, a first insulating layer made of anodically oxidized film and formed on the substrate so as to overlay each of the gate electrodes, a second insulating layer and a semiconductor layer positioned one above the other and formed so as to overlay the first insulating layer with the second insulating layer intervening between the semiconductor layer and the first insulating layer, and source and drain electrodes formed on the semiconductor layer, wherein each of the gate electrodes is of a double-layered structure including a first metal layer made of metal having a high electroconductivity and a second metal layer made of metal having a high property of being anodized, that is, being anodically oxidized, the present invention is effective to provide the improved thin film transistor array which, when applied in the large active matrix liquid crystal display, ensures a high-quality visual representation of image. Also, it is clear that the gate wiring having a low specific resistance enough to be applicable in the large-size thin film transistor array can be easily fabricated at a reduced cost while the insulation between the gate and source is accomplished of a degree similar to that accomplished according to the conventional technique.

## Claims

1. A thin film transistor array which comprises an insulating substrate (1); gate electrodes (2) formed on one surface of the substrate; a first insulating layer (6) made of anodically oxidized film and formed on the substrate so as to overlay each of the gate electrodes; a second insulating layer (7) and a semiconductor layer (8) positioned one above the other and formed so as to overlay the first insulating layer (6) with the second insulating layer (7) intervening between the semiconductor layer (8) and the first insulating layer (6); and source (11) and drain electrodes (13) formed on the semiconductor layer (8); characterized in that each of said gate electrodes (2) is of a double-layered structure including a first metal layer (4) made of metal having a high electrical conductivity and capable of being anodically oxidized and a second metal layer (5) made of metal capable of being anodically oxidized.

## Patentansprüche

1. Eine Dünnschichttransistoren-Matrix, die ein Isolationssubstrat (1), auf einer Oberfläche des Substrats ausgebildete Gate-Elektroden (2), eine erste aus einer anodisch oxidierten Schicht hergestellte und so auf dem Substrat ausgebildete Isolationsschicht (6), daß jede der Gate-Elektroden bedeckt wird, eine zweite Isolationsschicht (7) und eine Halbleiterschicht (8), die sich übereinander befinden und so ausgebildet sind, daß die erste Isolationsschicht (6) mit der zweiten Isolationsschicht (7), die zwischen der Halbleiterschicht (8) und der ersten Isolationsschicht (6) liegt, überdeckt wird, und auf der Halbleiterschicht (8) ausgebildete Source- (11) und Drain-Elektroden (13), aufweist, dadurch gekennzeichnet, daß jede der genannten Gate-Elektroden (2) eine doppelschichtige Struktur aufweist, die eine erste Metallschicht (4), die aus anodisch oxidierbarem Metall mit einer hohen elektrischen Leitfähigkeit besteht, und eine zweite Metallschicht (5) aufweist, die aus anodisch oxidierbarem Metall besteht.

## Revendications

1. Groupement de transistors à couches minces comportant un substrat isolant (1); des électrodes de grille (2) formées sur l'une des faces du substrat; une première couche isolante (6) faite d'un film soumis à une oxydation anodique et formée sur le substrat afin de recouvrir chacune des électrodes de grille; une seconde couche isolante (7) et une couche semi-conductrice (8) placées l'une au-dessus de l'autre et formées de façon à recouvrir la première couche isolante (6), la seconde couche isolante (7) étant interposée entre la couche semi-conductrice (8) et la première couche isolante (6); et des électrodes de source (11) et de drain (13) formées sur la couche semi-conductrice (8), caractérisé en ce que chacune desdites électrodes de grille (2) a une structure à deux couches comprenant une première couche de métal (4) faite d'un métal doté d'une forte conductivité électrique et apte à être soumis à une oxydation anodique et une seconde couche de métal (5) faite d'un métal apte à être soumis à une oxydation anodique.
